**Europäisches Patentamt**

**European Patent Office**

**Office européen des brevets**

(19)

(11) Numéro de publication: **0 065 437**
**B1**

(12)

# FASCICULE DE BREVET EUROPEEN

(45) Date de publication du fascicule du brevet:
03.07.85

(51) Int. Cl.⁴: **H 01 L 23/56, G 06 K 19/06**

(21) Numéro de dépôt: **82400724.9**

(22) Date de dépôt: **22.04.82**

(54) **Dispositif de protection des circuits électroniques tels que des circuits intégrés à l'encontre des charges électrostatiques.**

(30) Priorité: **30.04.81 FR 8108717**

(43) Date de publication de la demande:
**24.11.82 Bulletin 82/47**

(45) Mention de la délivrance du brevet:
**03.07.85 Bulletin 85/27**

(84) Etats contractants désignés:
**AT BE CH DE FR GB IT LI NL SE**

(56) Documents cités:
**EP - A - 0 037 760**
**FR - A - 1 430 438**
**GB - A - 1 251 456**
**US - A - 3 274 458**

(73) Titulaire: **COMPAGNIE INTERNATIONALE POUR L'INFORMATIQUE CII - HONEYWELL BULL (dite CII-HB), 94, avenue Gambetta, F-75020 Paris (FR)**

(72) Inventeur: **Ugon, Michel, 94 avenue Gambetta, F-75020 Paris (FR)**

(74) Mandataire: **Doireau, Marc et al, 94, avenue Gambetta, F-75020 Paris (FR)**

ACTORUM AG

## Description

L'invention a pour objet un dispositif de protection des circuits électroniques tels que des circuits intégrés à l'encontre des charges électrostatiques, et s'applique notamment à la protection des circuits intégrés montés sur un élément de support électriquement isolant; l'ensemble (circuits intégrés — élément de support) formant par exemple un support d'information portatif du type «carte de crédit».

L'avènement des microprocesseurs a permis une vulgarisation de la technique informatique dans des applications grand public. A l'heure actuelle, on développe précisément des supports d'informations portatifs personnalisés précités du type «carte de crédit». Une telle carte est constituée par un élément de support électriquement isolant sur lequel sont montés des dispositifs à circuits intégrés permettant d'enregistrer des informations d'ordre général et d'ordre confidentiel, et d'assurer une gestion interne et une gestion externe de ces informations.

Un dispositif à circuits intégrés a généralement la forme d'une pastille de quelques millimètres carrés, dont l'une des faces inclut des circuits électroniques et comporte des plots d'entrée-sortie reliés par des conducteurs de liaison à un réseau d'interconnexion porté par l'élément de support. Ce réseau d'interconnexion comprend des bornes d'entrée-sortie accessibles depuis l'extérieur pour assurer les liaisons externes indispensables.

Pour améliorer les propriétés mécaniques, thermiques et électriques d'une telle carte, il est généralement prévu un moyen de protection des dispositifs à circuits intégrés par un enrobage électriquement isolant qui enrobe partiellement l'élément de support de la carte en laissant dégagées les bornes d'entrée-sortie.

Etant donné sa nature et son caractère portatif, une telle carte est obligatoirement sujette à subir l'action des charges électrostatiques qui prendront naissance notamment sous l'action de divers frottements auxquels risque d'être soumis l'élément de support de la carte en période de non utilisation.

L'action de ces charges électrostatiques est d'autant plus sensible que ces circuits intégrés font notamment appel à des technologies à haut isolement comme par exemple la technologie MØS qui présente l'avantage de permettre une intégration à haute densité. En effet, la technologie MØS, notamment la technologie N. MØS, implique certaines protections contre les charges électrostatiques de toute nature risquant de détruire les circuits par claquage des espaces GATE-SOURCE.

L'invention vise à pallier cet inconvénient par l'utilisation d'un dispositif de protection destiné à isoler principalement les bornes d'entrée-sortie précitées accessibles depuis l'extérieur, afin d'éviter que les charges électrostatiques, emmagasinées au niveau de l'élément de support de la carte et qui se répartissent sur cet élément de support en fonction des divers frottements auxquels il risque d'être soumis, ne puissent provoquer des microarcs susceptibles de jaillir par effet de pointe entre l'élément de support et l'une des bornes d'entrée-sortie da le carte.

Un tel dispositif de protection est décrit dans la demande de brevet européen EP-A-0 037 760, qui fait partie de l'état de la technique au sens de l'article 54, paragraphe 3, de la Convention sur le Brevet Européen, et il est constitué par une enveloppe conductrice qui entoure les bornes d'entrée-sortie.

Toutefois, comme cette enveloppe est fermé, elle favorise la circulation des courants induits provoqués par les charges électrostatiques.

L'invention vise à pallier cet inconvénient pour augmenter l'efficacité de la protection et propose un dispositif de protection d'un circuit électronique tels que des circuits intégrés à l'encontre des charges électrostatiques, ces circuits électroniques étant montés sur un élément de support électriquement isolant et ayant des plots d'entrée-sortie reliés par un réseau d'interconnexion à des bornes d'entrée-sortie portées par ledit élément de support, accessibles depuis l'extérieur et regroupées en au moins une zone dudit élément de support, ce dispositif de protection étant constitué par au moins un élément conducteur porté par ledit élément de support et monté autour des bornes d'entrée-sortie regroupées dans ladite zone, caractérisé en ce que l'élément de protection est ouvert.

Un tel dispositif de protection a donc pour avantage de limiter les phénomènes de claquage au niveau des dispositifs à circuits intégrés, phénomènes qui sont provoqués notamment par des charges électrostatiques susceptibles d'être emmagasinées dans l'élément de support lors de sa manipulation par les utilisateurs. Une telle protection concourt à augmenter la durée de vie de la carte.

D'autres avantages, caractéristiques et détails ressortiront de la description explicative qui va suivre, faite en référence aux dessins annexés, donnés uniquement à titre d'exemple et dans lesquels:

la figure 1 est une vue de dessus agrandie d'un support d'informations telle qu'une carte de crédit incluant le dispositif de protection conforme à l'invention, et

la figure 2 est une vue en coupe schématique selon la ligne II-II de la figure 1.

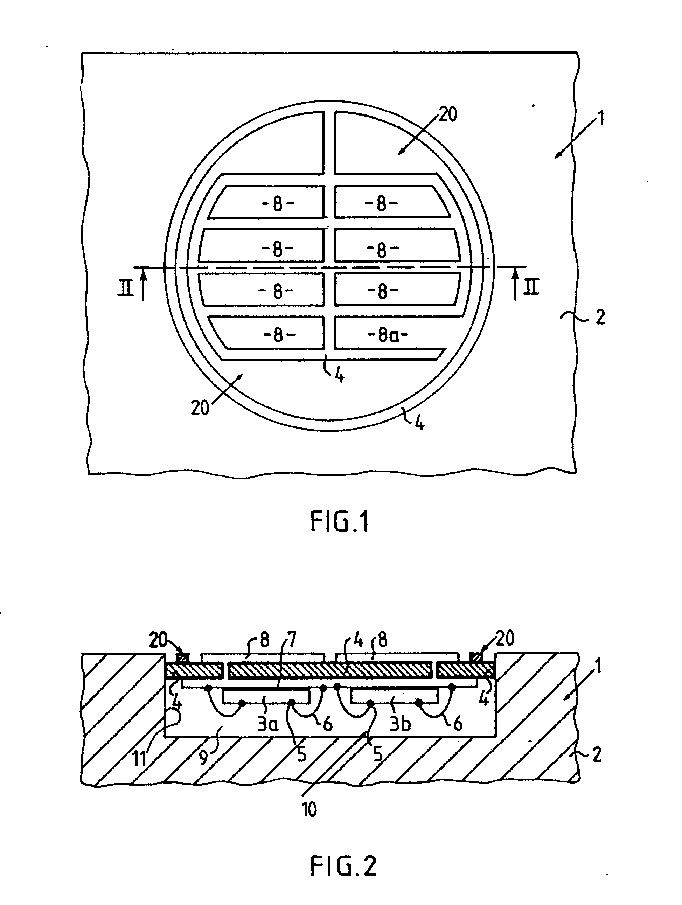

L'exemple de réalisation illustré aux figures 1 et 2 concerne un support d'informations personnalisé portatif (1) dénommé ci-après carte de crédit. Cette carte est équipée, conformément à l'invention, d'un dispositif de protection (20) à l'encontre des charges électrostatiques.

La carte (1) est essentiellement constituée:

— par un élément support (2) en chlorure de polyvinyle (PVC) par exemple, et

— par des dispositifs à circuits intégrés comme par exemple un microprocesseur (3a) et une mémoire morte programmable (3b) susceptibles de gérer des informations. Une telle carte (1) est notamment décrite dans le brevet français FR-A-2 401 459 et dans la demande de brevet français publié FR-A-2 439 478 de la Demanderesse.

En se reportant plus particulièrement à la figure 2, les dispositifs à circuits intégrés (3a) et (3b) sont supportés par un élément de support isolant auxiliaire (4) telle qu'une plaquette. Les plots d'entrée-sortie (5) de ces dispositifs à circuits intégrés (3a), (3b) sont respectivement reliés par des conducteurs de liaison (6) à un réseau d'interconnexion (7) également supporté par la plaquette (4). Ce réseau d'interconnexion (7) possède des bornes d'entrée-sortie (8) sous la forme de plages de contact accessibles depuis l'extérieur. Dans l'exemple illustré, les dispositifs à circuits intégrés (3a) et (3b) sont montés d'un côté de la plaquette (4), alors que les bornes d'entrée-sortie (8) sont situées sur l'autre face de la plaquette (4).

Par mesure de protection, les dispositifs à circuits intégrés (3a), (3b) sont protégés par un enrobage (9) électriquement isolant, enrobant partiellement la plaquette (4) et laissant dégagées les plages de contact (8), cet ensemble formant un boîtier (10).

Dans l'élément de support (2) en PVC constituant l'ossature de la carte (1), est prévu un orifice borgne (11) dans lequel est monté le boîtier (10) précédemment décrit avec les plages de contact (8) toujours accessibles depuis l'extérieur.

Conformément à l'invention, il est prévu un dispositif de protection (20) à l'encontre des charges électrostatiques susceptibles d'être emmagasinées par la carte (1). Ce dispositif de protection (20) est essentiellement constitué par un anneau métallique entourant les plages de contact (8), cet anneau étant par exemple porté par la plaquette (4) du boîtier (10).

Dans un tel ensemble, une des bornes d'entrée-sortie (8) fait office de borne de masse pour les dispositifs à circuits intégrés (3a) et (3b), soit (8a) cette borne. Avantageusement, conformément à une caractéristique de l'invention, l'anneau métallique de protection (20) peut être relié à cette borne de masse (8a).

Pour améliorer l'effet protecteur de l'anneau métallique (20), il est avantageux pour des raisons qui seront explicitées plus loin de prévoir les dispositions suivantes:

— regrouper les plages de contact (8) sur la plaquette (4) de façon à ce que ces plages de contact délimitent une surface minimum et ce, en prévoyant un espace libre minimum entre deux plages de contact adjacentes, et

— disposer l'anneau de protection (20) au voisinage immédiat de la surface précitée en laissant un espace minimum entre cet anneau (20) et la périphérie de ladite surface.

Du fait de la nature et du caractère portatif de la carte (1), cette carte est obligatoirement sujette à subir l'action des charges électrostatiques. Plus particulièrement, les charges électrostatiques emmagasinées par l'élément de support (2) en PVC de la carte se répartissent sur celle-ci en fonction des divers frottements auxquels est soumise la carte (1). En l'absence de l'anneau de protection (20), il y a possibilité de création de microarcs pouvant jaillir par effet de pointe entre l'élément de support (2) et l'une des bornes d'entrée-sortie (8), microarcs risquant d'endommager les dispositifs à circuits intégrés (3a), (3b), notamment lorsque ceux-ci sont constitués suivant une technologie MØS, par claquage des espaces GATE-SOURCE.

Par la présence de l'anneau de protection (20) qui entoure les bornes d'entrée-sortie (8), les microarcs précités se produiront au niveau de cet anneau évitant ainsi le risque d'endommagement des dispositifs à circuits intégrés (3a), (3b).

En limitant au maximum les espaces libres entre les bornes d'entrée-sortie (8) et entre ces bornes et l'anneau de protection (20), on limite l'accumulation des charges électrostatiques au niveau de la zone correspondante de la plaquette (4) et on limite d'autant l'action destructrice de ces charges.

Suivant une autre caractéristique de l'invention, l'anneau de protection (20) est ouvert, de façon à se protéger contre d'éventuels phénomènes d'induction bien connus en soi.

L'anneau de protection (20) forme donc une équipotentielle qui isole les bornes d'entrée-sortie (8) contre l'action des charges électrostatiques susceptibles de s'emmagasiner dans l'élément de support (2) de la carte (1). A l'intérieur de cet anneau de protection (20), on limite au maximum les espaces entre les contacts pour limiter l'accumulation de charges dans ces espaces. En outre, le fait de rapprocher les bornes d'entrée-sortie (8) offre l'avantage de répartir quasi uniformément les charges électrostatiques susceptibles de s'emmagasiner au niveau de ces bornes, ce qui permet de neutraliser l'action de ces charges.

L'anneau de protection (20) présente de préférence une surface relativement importante, de façon à ce qu'il soit en premier touché lors des manipulations avec les doigts par exemple. Comme l'anneau (20) est relié à la borne de masse (8a), toute décharge électrostatique s'écoulera normalement sans risquer d'endommager les dispositifs à circuits intégrés (3a), (3b). D'ailleurs il y a lieu également de réaliser ce contact de masse préalablement aux autres par la machine de transaction dans laquelle est insérer la carte (1), ce qui justifie la surface relativement importante de l'anneau de protection (20).

Bien évidemment, l'invention ne se limite pas à une application carte de crédit, mais à tout support d'informations comprenant des dispositifs à circuits intégrés conçus suivant une technologie sensible aux effets des charges électrostatiques. De plus, un même support d'informations auquel s'applique l'invention peut éventuellement posséder plusieurs anneaux de protection (20) en fonction du nombre de bornes d'entrée-sortie, bornes d'entrée-sortie qui ne peuvent pas éventuellement être regroupées en une même zone de surface relativement réduite.

## Revendications

1. Dispositif de protection de circuits électroniques tels que des circuits intégrés (3a, 3b) à l'encontre des charges électrostatiques, ces circuits électroniques étant montés sur un élément de support électriquement isolant (2, 4) et ayant des plots d'entrée-sortie (5) reliés par un réseau d'interconnexion (6, 7) à des bornes d'entrée-sortie (8) portées par ledit élément de support (4), accessibles depuis l'extérieur et regroupées en au moins une zone dudit élément de support (4), ce dispositif de protection étant constitué par au moins un élément conducteur (20) porté par ledit élément de support (4) et monté autour des bornes d'entrée-sortie (8) regroupées dans ladite zone, caractérisé en ce que l'élément de protection (20) est ouvert pour éviter la circulation des courants induits provoqués par lesdites charges électrostatiques.

2. Dispositif selon la revendication 1, caractérisé en ce que l'element (20) précité est électriquement relié à l'une des bornes d'entrée-sortie (8) précitée, avantageusement à la borne d'entrée-sortie (8a) faisant office de masse.

3. Dispositif selon la revendication 1 ou 2, caractérisé en ce que les bornes d'entrée-sortie (8) précitées se présentent sous la forme de plages conductrices disposées à proximité immédiate les unes des autres, l'élément de protection (20) précité étant lui-même à proximité immédiate du contour périphérique externe délimité par l'ensemble desdites plages conductrices.

4. Dispositif selon l'une des revendications précédentes, caractérisé en ce que les circuits électroniques précités comprennent un microprocesseur (3a) et une mémoire morte programmable (3b) qui forment avec l'élément de support électriquement isolant (2, 4) précité, un support d'informations portatif telle qu'une carte de crédit.

5. Carte de crédit, caractérisée en ce qu'elle est équipée d'un dispositif de protection tel que défini selon l'une des revendications précédentes.

## Patentansprüche

1. Schutzvorrichtung für elektronische Schaltkreise wie integrierte Schaltungen (3a, 3b) gegen elektrostatische Ladungen, wobei diese elektronischen Schaltkreise auf einem elektrisch isolierenden Trägerelement (2, 4) montiert sind und Eingangs/Ausgangs-Klötzchen (5) aufweisen, welche über ein Verbindungsnetzwerk (6, 7) mit Eingangs/Ausgangs-Anschlüssen (8) verbunden sind, welche das genannte Trägerelement (4) trägt und die von der Aussenseite her zugänglich sowie in wenigstens einer Zone des genannten Trägerelementes (4) gruppiert sind, wobei die Schutzvorrichtung durch wenigstens ein Leiterelement (20) gebildet ist, welches von dem Trägerelement (4) getragen wird und um die in der genannten Zone gruppierten Eingangs/Ausgangs-Anschlüsse (8) herum angebracht ist, dadurch gekennzeichnet, dass das Schutzelement (20) offen ist, um das Fliessen von induzierten Strömen zu verhindern, welche durch die genannten elektrostatischen Ladungen hervorgerufen werden.

2. Vorrichtung nach Anspruch 1, dadurch gekennzeichnet, dass das genannte Element (20) elektrisch mit einem der genannten Eingangs/Ausgangs-Anschlüsse (8) verbunden ist, in vorteilhafter Weise mit dem Eingangs/Ausgangs-Anschluss (8a), der als Masse dient.

3. Vorrichtung nach Anspruch 1 oder 2, dadurch gekennzeichnet, dass die Eingangs/Ausgangs-Anschlüsse (8) in Form von leitenden Flächenbereichen in unmittelbarer Nähe voneinander angeordnet sind und das genannte Schutzelement (20) seinerseits in unmittelbarer Nähe der äusseren Umfangskontur durch die Gesamtheit der genannten leitenden Flächenbereiche begrenzt ist.

4. Vorrichtung nach einem der vorstehenden Ansprüche, dadurch gekennzeichnet, dass die genannten elektronischen Schaltkreise einen Mikroprozessor (3a) und einen programmierbaren Festwertspeicher (3b) umfassen, die mit dem elektrisch isolierenden genannten Trägerelement (2, 4) einen tragbaren Informationsträger wie eine Kreditkarte bilden.

5. Kreditkarte, dadurch gekennzeichnet, dass sie mit einer Schutzvorrichtung nach einem der vorstehenden Ansprüche ausgestattet ist.

## Claims

1. Device for protecting electronic circuits such as integrated circuits (3a, 3b) against electrostatic charges, these electronic circuits being mounted on an electrically insulating support element (2, 4) and having input-output terminals (5) connected by an interconnecting network (6, 7) to input-output terminals (8) carried by the said support element (4), which are accessible from the outside and grouped in at least one zone of the said support element (4), this protection device being formed by at least one conductive element (20) carried by the said support element (4) and disposed around the input-output terminals (8) grouped in the said zone, characterised in that the protective element (20) is open in order to avoid the flow of the induced currents produced by the said electrostatic charges.

2. Device according to claim 1, characterised in that the said element (20) is connected electrically to one of the said input-output terminals (8), advantageously to the input-output terminal (8a) acting as an earth.

3. Device according to claim 1 or 2, characterised in that the said input-output terminals (8) are in the form of conductive areas disposed in direct proximity to each other, the said protective element (20) itself being in direct proximity to the external peripheral outline delimited by the totality of the said conductive areas.

4. Device according to any of the preceding claims, characterised in that the said electronic circuits comprise a microprocessor (3a) and a programmable ROM (3b) which with the said electrically insulating element (2, 4) form a portable data carrier such as a credit card.

5. Credit card characterised in that it is equipped with a protective device as defined according to any of the preceding claims.

FIG.1

FIG.2